(19) Europäisches Patentamt
European Patent Office
Office européen des brevets

(11) Numéro de publication: **0 246 137 B1**

# (12) FASCICULE DE BREVET EUROPEEN

(45) Date de publication du fascicule du brevet: **04.04.90**

(51) Int. Cl.⁴: **G01R 33/38**

(21) Numéro de dépôt: **87400991.3**

(22) Date de dépôt: **29.04.87**

(54) **Bloc correcteur d'homogénéité de champ magnétique, et aimant muni de tels blocs.**

(30) Priorité: **13.05.86 FR 8606862**

(43) Date de publication de la demande: **19.11.87 Bulletin 87/47**

(45) Mention de la délivrance du brevet: **04.04.90 Bulletin 90/14**

(84) Etats contractants désignés: **CH DE GB IT LI NL**

(56) Documents cités:
**WO-A-84/00611**

**REVIEW OF SCIENTIFIC INSTRUMENTS, vol. 56, no. 1, janvier 1985, pages 131-135, New York, US; D.I. HOULT et al.: "Shimming a superconducting nuclear-magnetic-resonance imaging magnet with steel"**
**PATENT ABSTRACTS OF JAPAN, vol. 9, no. 174 (P-374)[1897], 19 juillet 1985; & JP-A-60 50 442 (YOKOKAWA MEDICAL SYSTEM K.K.) 20-03-1985**
**PATENT ABSTRACTS OF JAPAN, vol. 8, no. 163 (P-290)[1600], 27 juillet 1984; & JP-A-59 60 346 (TOSHIBA K.K.) 06-04-1984**

(73) Titulaire: **GENERAL ELECTRIC CGR S.A., 100, rue Camille-Desmoulins, F-92130 Issy les Moulineaux(FR)**

(72) Inventeur: **Aubert, Guy, THOMSON-CSF SCPI 19, avenue de Messine, F-75008 Paris(FR)**

(74) Mandataire: **Ballot, Paul Denis Jacques et al, Cabinet Ballot-Schmit 7, rue le Sueur, F-75116 Paris(FR)**

EP 0 246 137 B1

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

## Description

La présente invention est due à la collaboration du Service National des Champs Intenses (Directeur M. Guy AUBERT), et elle a pour objet un bloc correcteur d'homogénéité pour le réglage et la correction du champ magnétique produit par un aimant. Elle a également pour objet un aimant muni de tels blocs. Elle trouve son application particulièrement dans le domaine médical où des aimants sont utilisés pour procéder à des investigations non invasives, en appliquant des méthodes d'imageries par résonance magnétique nucléaire. Elle peut néanmoins trouver son application dans d'autres domaines, notamment dans celui de la recherche scientifique où des champs intenses produits par des aimants sont utilisés.

La résonance magnétique est un phénomène d'oscillation du moment magnétique des noyaux des atomes ou molécules d'un corps à une fréquence qui dépend de l'intensité d'un champ magnétique dans lequel baigne ce corps. Il en ressort que si l'intensité du champ magnétique varie la fréquence du phénomène de résonance varie également. Aussi, pour des raisons technologiques et techniques, dans de telles expérimentations, il est de la plus haute importance que le champ produit par l'aimant soit très homogène dans sa zone d'intérêt. L'homogénité requise est couramment de l'ordre de quelques parties par millions dans le domaine médical, voire de quelques parties par milliards dans le domaine scientifique. Pour arriver à ce but, on essaye de construire des aimants donnant un champ le plus parfaitement homogène.

Malheureusement, quel que soit le soin apporté à la construction des aimants, leur réalisation n'est jamais aussi parfaite que la théorie qui a conduit à leur calcul. Par ailleurs même si ce défaut peut être éliminé, l'aimant pour être utilisé doit matériellement être placé en un endroit donné. Or aucune des régions de l'espace sur la terre, dans un environnement industriel ou urbain, n'est totalement exempte d'éléments magnétiques perturbateurs. Il en résulte qu'une fois installé sur site, le champ produit dans la zone d'intérêt d'un aimant présente des inhomogénéités qu'il faut maintenant tenter de corriger.

Le principe de la correction des inhomogénéités de champ est celui de la superposition : on ajoute des bobines, des pièces magnétiques, ou tout autre moyen de produire des champs magnétiques de manière à corriger les imperfections du champ principal et de manière à produire un champ global homogène. Dans un article de Rev. Sci. Instrum. de Janvier 1985, dû à Messieurs D. I. HOULT et D. LEE, intitulé "Shimming a superconducting nuclear - magnetic- resonance imaging magnet with steel", page 131 à 135, il est décrit un procédé de correction du champ magnétique produit par un aimant. Selon ce procédé on utilise des barreaux de fer doux aimantables que l'on place de telle manière qu'ils exercent leur influence dans une zone d'intérêt de l'aimant. Le degré de cette influence dépend de la taille des barreaux : plus leur section est importante plus l'éfficacité de la correction est grande. Ce procédé de correction présente un inconvénient : de telles pièces magnétiques doivent être taillées sur mesure pour chaque application. En outre, compte tenu de la complexité de la théorie de la correction, les auteurs admettent pour simplifier leur solution que les éléments magnétiques ne peuvent être placés qu'en des endroits prédéterminés et avec des orientations radiales ou annulaires à l'intérieur de l'aimant. Il en résulte que la correction du champ produit par un aimant ne peut pas facilement être menée à bien sans la fabrication et la mise en place à la demande de barreaux de correction.

La présente invention propose de résoudre le problème du réglage du champ d'un aimant d'une autre manière. Des blocs correcteurs magnétiques d'éfficacité intrinsèque donnée sont fixés sur des supports à proximité du champ à corriger. Les supports de ces blocs présentent alors la particularité d'être orientables. On peut ainsi modifier la contribution au champ magnétique de l'aimant produite dans la zone d'influence de ces blocs. Ces blocs correcteurs magnétiques sont des morceaux d'aimant permanent à haut champ coercitif et à grande anisotropie (aimants à base de terres rares par exemple), suffisants pour que leur aimantation ne soit pas sensiblement modifiée par le champ qui règne à l'endroit où ils sont placés. Par ailleurs les supports orientables de l'invention possèdent des graduations de pointage qui permettent de quantifier la correction. La correction proprement dite est menée, d'une manière préférée, selon un procédé de réglage décrit dans une demande de brevet due au même inventeur et déposée le même jour au nom du même demandeur. L'enseignement de cette précédente demande de brevet est rappelée plus loin, ainsi que la manière de l'appliquer à la présente invention.

L'invention a pour objet un bloc correcteur magnétique pour le réglage de l'homogénéité du champ magnétique produit par un aimant, ledit bloc étant maintenu à proximité du champ à régler par un support, et étant caractérisé en ce que le support comporte des moyens pour régler l'orientation du bloc. Elle a également pour objet un aimant muni de tels blocs.

L'invention sera mieux comprise à la lecture de la description qui suit et à l'examen des figures qui l'accompagnent. Elles ne sont données qu'à titre indicatif et nullement limitatif de l'esprit de l'invention. Les figures représentent :

- figure 1, un bloc correcteur magnétique orientable selon l'invention,
- figure 2, un exemple d'utilisation de bloc selon l'invention dans un appareil d'imagerie par résonance magnétique nucléaire.

La figure 1 représente un bloc de matériau magnétique aimanté de façon permanente maintenu par un support 2 et produisant en un point quelconque de son environnement un champ magnétique. Le support 2 est approché d'une zone d'intérêt 3 où règne un champ magnétique $B_0$ à modifier, à corriger. Dans un

exemple le volume d'intérêt 3 est intérieur à des moyens 4 pour produire le champ $B_0$. Les moyens 4 peuvent être un agencement de bobines éléctriques de tous types, éventuellement de type Bitter. Mais le champ $B_0$ peut aussi être produit par tous autres moyens, notamment par des pièces polaires en matériau d'aimant permanent et le support 2 est alors fixé à une structure 4 disposée autour de la zone d'intérêt 3 de cet aimant.

Une particularité de l'invention concerne la nature orientable de la cale magnétique 1 dans le support 2. Dans la représentation de la figure 1 le support 2 comporte une pièce support proprement dite 5, une pièce intermédiaire orientable 6, et une pièce de fixation également orientable 7. La pièce 6 possède un degré de liberté en rotation par rapport à la pièce 5. De même la pièce 7 est libre en rotation, avec un degré de liberté, par rapport à la pièce 6. D'une manière préférée, comme représenté içi, les axes de rotation 10 et 11 des pièces 6 et 7 sont orthogonaux, voire même perpendiculaires. Le glissement en rotation de la pièce intermédiaire 6 dans la pièce support 5 peut être obtenu par l'intermédiaire d'un palier. Par exemple la couronne extérieure de ce palier est fixée à la pièce support 5, et la couronne intérieure à la pièce intermédiaire 6. La pièce de fixation 7 peut avoir l'allure d'un arbre tronçonné en deux parties, respectivement 8 et 9, aboutées et alignées sur deux faces opposées du bloc 1. A leurs autres bouts les tronçons 8 et 9 sont maintenus dans la pièce intermédiaire 6, par deux paliers.

D'une manière préférée les axes de rotations 10 et 11 sont perpendiculaires et se coupent à l'endroit 13 du centre de gravité du bloc 1. Dans une réalisation préférée la plus grande dimension du bloc 1 est inférieure au diamètre intérieur de la pièce intermédiaire 6. Il en résulte que l'orientation 12 du moment magnétique du bloc 1 peut prendre une orientation quelconque par rapport au champ $B_0$. En fonction de son orientation privilégié 12, le bloc magnétique 1 peut être représenté comme comportant un pôle nord N et un pôle sud (non figuré). Les lignes de champ du champ produit par le bloc 1 sortent de son pôle nord et se referment par son pôle sud. Le long de ces lignes de champ, le champ produit par le bloc 1 varie en valeur et en orientation selon une distribution qui peut être connue connaissant la forme et l'aimantation du bloc. Les pièces support, intermédiaire, et de fixation du bloc comportent des indications 55 à 57 qui défilent mutuellement les unes devant les autres lors du réglage. Ces indications permettent de mesurer les angles de pointage. Par ailleurs pour éviter le dereglage il peut être ajouté des moyens de frottement ou de bloquage pour maintenir le bloc dans son orientation lorsqu'il est reglé.

La figure 2 représente, en exemple, schématiquement et en perspective, un appareil d'imagerie par résonance magnétique nucléaire du type de ceux utilisés dans le domaine médical. Un aimant 4 y produit un champ intense $B_0$ dans le volume d'intérêt 3 ici d'aspect cylindrique circulaire. Des moyens générateur 18, sous le contrôle d'une unité de commande 19, sont prévus pour alimenter des moyens 20 d'excitation radiofréquence et de différenciation spatiale des moments magnétiques des noyaux des atomes et molécules du corps placé pour examen dans le volume 3. Les moyens 20, notamment dans leur aspect radiofréquence, sont aussi utilisés pour mesurer une onde de désexcitation représentative du phénomène de résonance magnétique. Ils sont reliés à des moyens 21 de réception et de traitement du signal mesuré. Les moyens 21, également sous le contrôle des moyens de commande 19, peuvent produire des images de coupe du corps examiné. Ces images peuvent être affichées sur des moyens de visualisation 22.

Le réglage de l'orientation des blocs va être décrit dans cet exemple. Les moyens 4 produisent un champ $B_0$, si possible très homogène, dans la zone d'intérêt 3 intérieure. L'homogénéité parfaite dans la zone 3 n'étant pas atteinte, elle peut être corrigée selon l'invention au moyen d'un certain nombre de blocs magnétiques. Ces blocs peuvent être placés par exemple à la périphérie extérieure des moyens 4. De manière à simplifier la mise en place, il peut être utile de prévoir sur la structure 4 un ensemble d'emplacements usinés pour permettre une fixation rapide des blocs.Par ailleurs les blocs peuvent avoir des tailles ou des aimantations différentes.

Comme rappelé dans la demande de brevet précédemment citée il est possible, en mesurant le champ $B_0$ en tous points du volume 3, d'en donner une expression analytique sous la forme suivante :

$$\frac{B_z(r,\theta,\varphi)}{B_s} = H_0 + \sum_{n=1}^{\infty} \left(\frac{r}{r_0}\right)^n \left[ H_n \cdot P_n (\cos\theta) \right]$$

$$+ \sum_{n=1}^{\infty} \left(\frac{r}{r_0}\right)^n \left[ \sum_{m=1}^{m=n} I_n^m \cos m\varphi \sqrt{\frac{(n-m)!}{(n+m)!}}\; P_n^m (\cos\theta) \right]$$

$$+ \sum_{n=1}^{\infty} \left(\frac{r}{r_0}\right)^n \left[ \sum_{m=1}^{m=n} J_n^m \sin m\varphi \sqrt{\frac{(n-m)!}{(n+m)!}}\; P_n^m (\cos\theta) \right]$$

Dans cette formule $B_z$ est la composante, selon l'axe 23 de la structure cylindrique circulaire, du champ $B_0$ crée par l'aimant 4; $B_s$ est un champ de référence permettant de définir des coefficients $H_n$,$I_n^m$ et $J_n^m$ sans dimension. Le rayon réduit $r/r_0$ mesure le module de la distance r d'un point quelconque du volume d'intérêt au rayon $r_0$ une sphère utile. Les fonctions $P_n$ (cos θ) et $P_n^m$ (cos θ) sont les polynômes de Legendre respectivement d'ordre n et de degré m. Les coefficients $H_n$, $I_n^m$ et $J_n^m$ sont représentatifs du champ $B_0$ : pour un champ $B_z$ mesuré ils sont connus. Dans la pratique un ordinateur 27 peut être programmé pour accomplir ce calcul des coefficients $H_n$,$I_n^m$, $J_n^m$, de l'expression analytique à partir des mesures. Par ailleurs il est tout à fait possible de donner la correspondance qui existe entre les coordonnés sphèriques r, θ, et ρ des points dans l'expression analytique et des coordonnées cylindriques qui peuvent servir lors de la mesure du champ.

Ces coordonnées cylindriques représentent en particulier les diverses positions que peut prendre une sonde 24 reliée à un Gaussmètre 25 quand elle est déplacée, au moyen d'un dispositif d'exploration 26, à l'intérieur du volume 3. Le dispositif d'exploration 26 comporte schématiquement un arbre 28 qui peut coulisser et tourner sur lui-même à l'intérieur d'un palier 29. L'arbre 28 est aligné avec l'axe 23 du volume cylindrique circulaire 3. A un bout de l'arbre 28 est montée une échelle transversale 30 sur laquelle peut être fixée la sonde 24. Suivant la position en rotation de l'arbre 28, l'échelle 30 est orientée selon une parmi np directions possibles. La hauteur de la position de la sonde 24 sur l'échelle 30 peut être prise parmi nr positions possibles. Enfin l'arbre 28 peut coulisser dans le support 29 pour que la sonde puisse se trouver successivement à nz cotés le long de l'axe 23. Le Gaussmètre 25 peut être relié directement à l'ordinateur 27. Celui-ci peut éditer une liste 31 des valeurs mesurées du champ et calculer les coefficients de l'expression analytique.

Connaissant la position d'un bloc et l'orientation de son moment magnétique il est possible de calculer l'expression analytique du champ qu'il crée. Selon l'enseignement de la précedente demande de brevet, il est proposé de combiner algébriquement des expressions analytiques des moyens de correction du champ de manière à produire une expression analytique dite de correction. Cette expression analytique de correction est représentative d'un champ de correction, qui, associé au champ réel, le transforme en un champ idéal recherché. Des résultats de cette composition algébrique on déduit les paramètres applicables au réglage des moyens de correction.

Pour les blocs correcteurs de l'invention il en va de même. Le réglage s'applique au nombre et à la position des blocs, à l'orientation et à la grandeur de leur moment magnétique. Considérons par exemple un bloc correcteur 14 dont la position est caractérisée par les coordonnées sphériques $R_0$, $\theta_0$, $\rho_0$ par rapport au réferentiel 16,x,y,z. Le moment de son bloc, de grandeur M, a une orientation caractérisée par les angles des coordonnées sphériques $\theta_1$ et $\rho_1$ par rapport au référentiel x',y',z' situé en 14 et déduit par la translation $R_0$, $\theta_0$, $\phi_0$ du référentiel 16. Le champ crée dans la zone d'intérêt par le bloc correcteur a une expression analytique suivant la forme générale donnée plus haut avec des coefficients $H_{n\,cor}$, $I_{n\,cor}^m$, $J_{n\,cor}^m$, fonction de M, $\theta_1$, $\rho_1$, $R_0$,$\theta_0$,$\phi_0$. On peut alors programmer un ordinateur pour déterminer le nombre minimum $N_{min}$ de blocs correcteurs nécessaires, avec leurs paramètres de grandeur du moment (M), d'orientation ($\theta_1$, $\rho_1$) et de position ($R_0$, $\theta_0$, $\rho_0$), pour produire un champ magnétique qui, superposé au champ original de l'aimant 4, s'approche d'aussi près que l'on veut du champ idéal souhaité. Le programme prend en considération d'une manière préférée des contraintes supplémentaires :
- M égal à une valeur choisie dans un ensemble prédéterminé ce qui permet à un opérateur de disposer d'un certain choix de blocs de la même façon que l'on dispose de masses marquées pour effectuer une pesée,
- $R_0$, $\theta_0$, $\rho_0$ correspondant à l'une des positions prédéterminées par les emplacements usinés pour recevoir les connecteurs.

Par contre, suivant la disposition préférée de l'invention, l'orientation ($\theta_1$, $\rho_1$) du moment magnétique peut être réglée sans contrainte au moyen du support représenté à la figure 1. Le programme à composer met en oeuvre conjointement deux traitements. Premièrement il permet le calcul analytique du champ produit par le bloc. Un exemple d'un tel calcul est décrit dans un article de F. ROMEO et D.I. HOULT paru dans la revue MAGNETIC RESONANCE IN MEDICINE 1,44-65 de 1984, et intitulé "MAGNET FIELD PROFILING : ANALYSIS AND CORRECTION COIL DESIGN".

En outre ce programme pour calculer $N_{min}$ et les M, $\theta_1$, $\rho_1$, $R_0$, $\theta_0$ et $\rho_0$ doit effectuer un traitement de minimisation de fonctions. Le problème de minimisation d'une fonction non linéaire de plusieurs variables avec contraintes est classique et parfaitement résolu par calculs itératifs au moyen d'un ordinateur. Des programmes appelés "routines" capables de mener à bien de tels processus de minimisation sont disponibles dans la plupart des "librairies" associées à un centre de calcul scientifique. On peut utiliser par exemple la "routine" EO4UAF de la libraire "Numerical Algorithms Group" d'origine britannique. La programmation des expressions analytiques exprimées ci-dessus, en vue de la mise en oeuvre de la "routine", est alors à la portée de l'homme de métier.

Ces correcteurs peuvent être utilisés en combinaison avec des bobines correctrices parcourues par des courants ou avec des pièces de fer doux placées à l'intérieur de l'aimant. La combinaison la plus efficace et, ou la plus économique doit être appréciée par l'homme de métier.

**Revendications**

1 - Bloc correcteur magnétique (1) pour le réglage de l'homogénéité du champ ($B_0$) magnétique produit par un aimant (4), ledit bloc étant maintenu à proximité du champ à régler par un support (2), et étant caractérisé en ce que le support comporte des moyens (4 -11) pour régler l'orientation (12) du bloc.

2 - Bloc selon la revendication 1 caractérisé en ce que l'aimant comporte des bobines (4) entourant un volume intérieur (3) d'intérêt, et en ce que le support (14) est fixé à la surface extérieure de ces bobines.

3 - Bloc selon l'une quelconque des revendications 1 ou 2 caractérisé en ce que les moyens pour régler l'orientation comportent des moyens pour orienter le bloc dans toutes les directions (12).

4 - Bloc selon la revendication 3 caractérisé en ce que les moyens pour régler l'orientation comportent une pièce intermédiaire (6) orientable (10) par rapport au support (5) selon des orientations contenues dans un premier plan, fixe par rapport au support, et une pièce de fixation (7) orientable (11) par rapport à la pièce intermédiaire (6) selon des orientations contenues dans un deuxième plan, fixe par rapport à cette pièce intermédiaire.

5 - Bloc selon la revendication 4 caractérisé en ce que la pièce intermédiaire comporte une couronne placée à plat dans le premier plan.

6 - Bloc selon la revendication 5 caractérisé en ce que la pièce de fixation comporte un arbre (8,9) diamétralement agencé à l'intérieur de la couronne et en ce que l'arbre est composé de deux tronçons alignés l'un avec l'autre et aboutés de part et d'autre du bloc.

7 - Bloc selon l'une quelconque des revendications 1 à 6 caractérisé en ce qu'il comporte un morceau d'aimant permanent.

8 - Bloc selon la revendication 7 caractérisé en ce que le morceau d'aimant possède une aimantation dont la valeur a été choisie parmi un ensemble fini de valeurs prédeterminées.

9 - Bloc selon l'une quelconque des revendications 4 à 7 caractérisé en ce que la pièce intermédiaire et / ou la pièce de fixation comportent des indications graduées (55 - 57) pour défiler en regard d'indications graduées portées sur le support et/ou respectivement sur la pièce intermédiaire.

10 - Aimant caractérisé en ce que il est muni d'un ou plusieurs blocs selon l'une quelconque des revendications 1 à 9.

11 - Aimant selon la revendication 10 caractérisé en ce qu'il comporte un ensemble d'emplacements préusinés pour recevoir les blocs.

**Claims**

1. A magnetic correcting block (1) for the adjustment of the homogeneity of the magnetic field ($B_0$) produced by a magnet (4), the said block being maintained in the proximity of the field to be adjusted by a support (2) and being characterized in that the support comprises means (4 through 11) for adjustment of the orientation (12) of the block.

2. The block as claimed in claim 1 characterized in that the magnet comprises coils (4) surrounding an interior space (3) in question and in that the support (14) is secured to the outside surface of these coils.

3. The block as claimed in either of the claims 1 and 2 characterized in that the means for adjusting the orientation comprise means for orientating the block in all directions (12).

4. The block as claimed in claim 3 characterized in that the means for adjustment of orientation comprise an intermediate member (6) able to be orientated (10) in relation to the support (5) in accordance with directions contained in a first plane, fixed in relation to the support, and a locking member (7) able to be orientated (11) in relation to the intermediate member (6) in accordance with directions contained in the second plane, fixed in relation to this intermediate member.

5. The block as claimed in claim 4 characterized in that the intermediate member comprises a crown placed flatwise in the first plane.

6. The block as claimed in claim 5 characterized in that the locking member comprises a shaft (8 and 9) diametrally fitted inside the crown and in that the shaft is made up of two limbs aligned with each other and abutting the block on both sides.

7. The block as claimed in any one of the claims 1 through 6 characterized in that it comprises a piece of permanent magnet.

8. The block as claimed in claim 7 characterized in that the piece of magnet possesses a magnetization whose value has been selected from a finite set of predetermined values.

9. The block as claimed in any one of the claims 4 through 7 characterized in that the intermediate member and/or the locking member comprise graduated markings (55 through 57) inorder to move past in front of graduated markings made on the support and/or, respectively, on the intermediate member.

10. A magnet characterized in that it is provided with one or more blocks in accordance with any one of the claims 1 through 9.

11. The magnet as claimed in claim 10 characterized in that it comprises a set of prefabricated locations in order to receive the blocks.

## Patentansprüche

1. Magnetischer Korrekturblock (1) für die Einstellung der Homogenität des durch einen Magnet (4) erzeugten Magnetfeldes ($B_0$), wobei dieser Block durch einen Träger (2) in der Nähe des einzustellenden Feldes festgehalten wird, dadurch gekennzeichnet, daß der Träger Mittel (4–11) zur Einstellung der Orientierung (12) des Blocks umfaßt.

2. Block nach Anspruch 1, dadurch gekennzeichnet, daß der Magnet Spulen (4) umfaßt, die ein interessierendes Innenvolumen (3) umgeben, und daß der Träger (14) an der Außenfläche dieser Spulen befestigt ist.

3. Block nach Anspruch 1 oder 2, dadurch gekennzeichnet, daß die Mittel zur Einstellung der Orientierung Mittel zur Orientierung des Blocks nach allen Richtungen (12) umfassen.

4. Block nach Anspruch 3, dadurch gekennzeichnet, daß die Mittel zur Einstellung der Orientierung ein Zwischenteil (6), das in bezug auf den Träger (5) gemäß in einer ersten Ebene enthaltenen Orientierungen einstellbar (10) ist, welche in bezug auf den Träger fest ist, sowie ein Befestigungsteil (7) umfassen, das in bezug auf das Zwischenteil (6) gemäß in einer zweiten Ebene enthaltenen Orientierungen einstellbar (11) ist, welche in bezug auf dieses Zwischenteil fest ist.

5. Block nach Anspruch 4, dadurch gekennzeichnet, daß das Zwischenteil einen in der ersten Ebene flach angeordneten Kranz umfaßt.

6. Block nach Anspruch 5, dadurch gekennzeichnet, daß das Befestigungsteil eine Welle (8, 9) umfaßt, die im Inneren des Kranzes diametral angeordnet ist, und daß die Welle aus zwei Abschnitten gebildet ist, die aufeinander ausgerichtet und beiderseits des Blocks aneinandergefügt sind.

7. Block nach einem der Ansprüche 1 bis 6, dadurch gekennzeichnet, daß er ein Permanentmagnetstück umfaßt.

8. Block nach Anspruch 7, dadurch gekennzeichnet, daß das Magnetstück eine Magnetisierung aufweist, deren Wert unter einer begrenzten Gruppe vorbestimmter Werte ausgewählt wurde.

9. Block nach einem der Ansprüche 4 bis 7, dadurch gekennzeichnet, daß das Zwischenteil und/oder das Befestigungsteil gestufte Angaben (55–57) umfassen, um gegenüber gestuften Angaben vorbeizulaufen, die jeweils auf dem Träger und/oder auf dem Zwischenteil angebracht sind.

10. Magnet, dadurch gekennzeichnet, daß er mit einem Block oder mit mehreren Blöcken nach einem der Ansprüche 1 bis 9 versehen ist.

11. Magnet nach Anspruch 10, dadurch gekennzeichnet, daß er eine Gruppe von vorbearbeiteten Stellen zum Aufnehmen der Blöcke umfaßt.

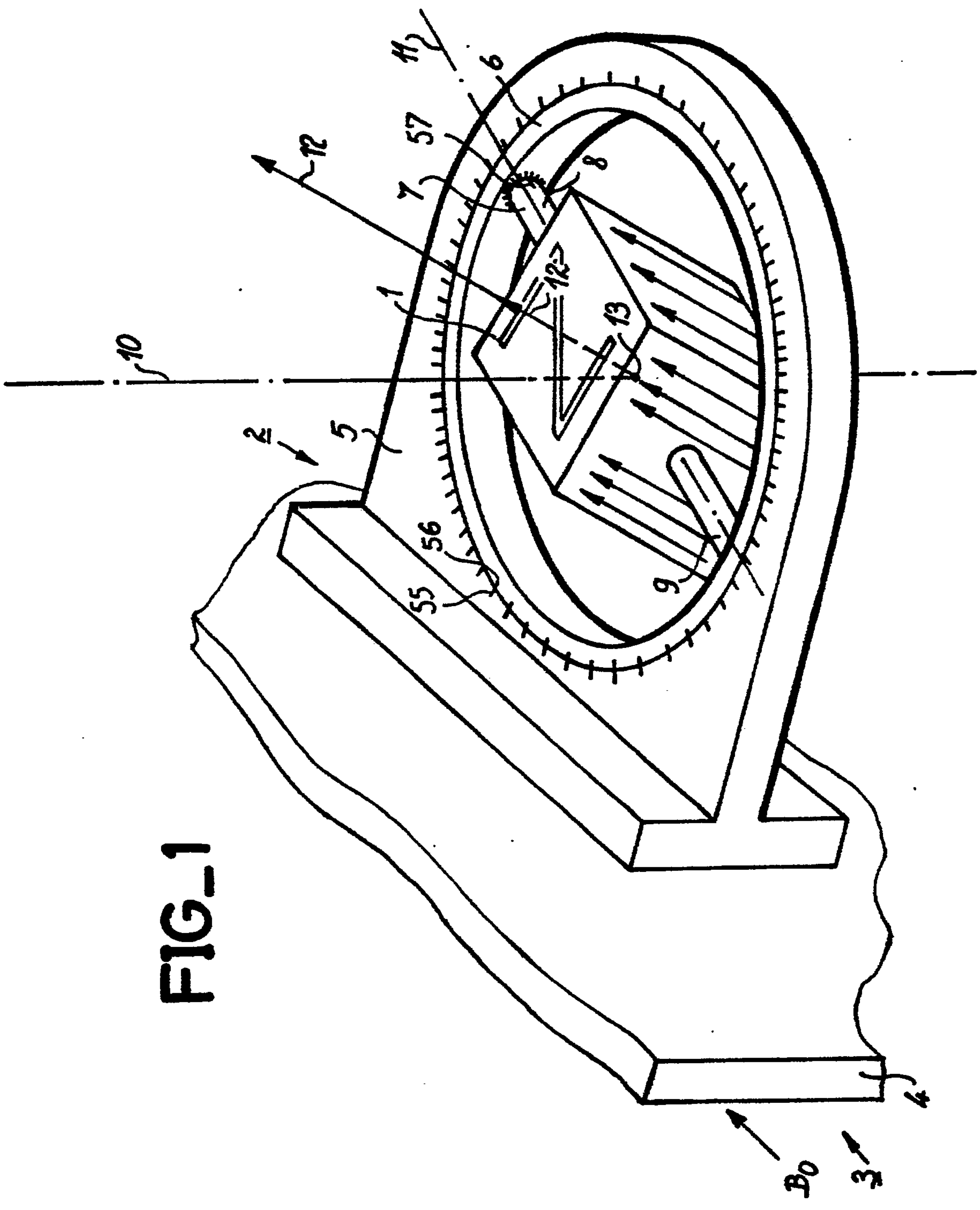


FIG_1

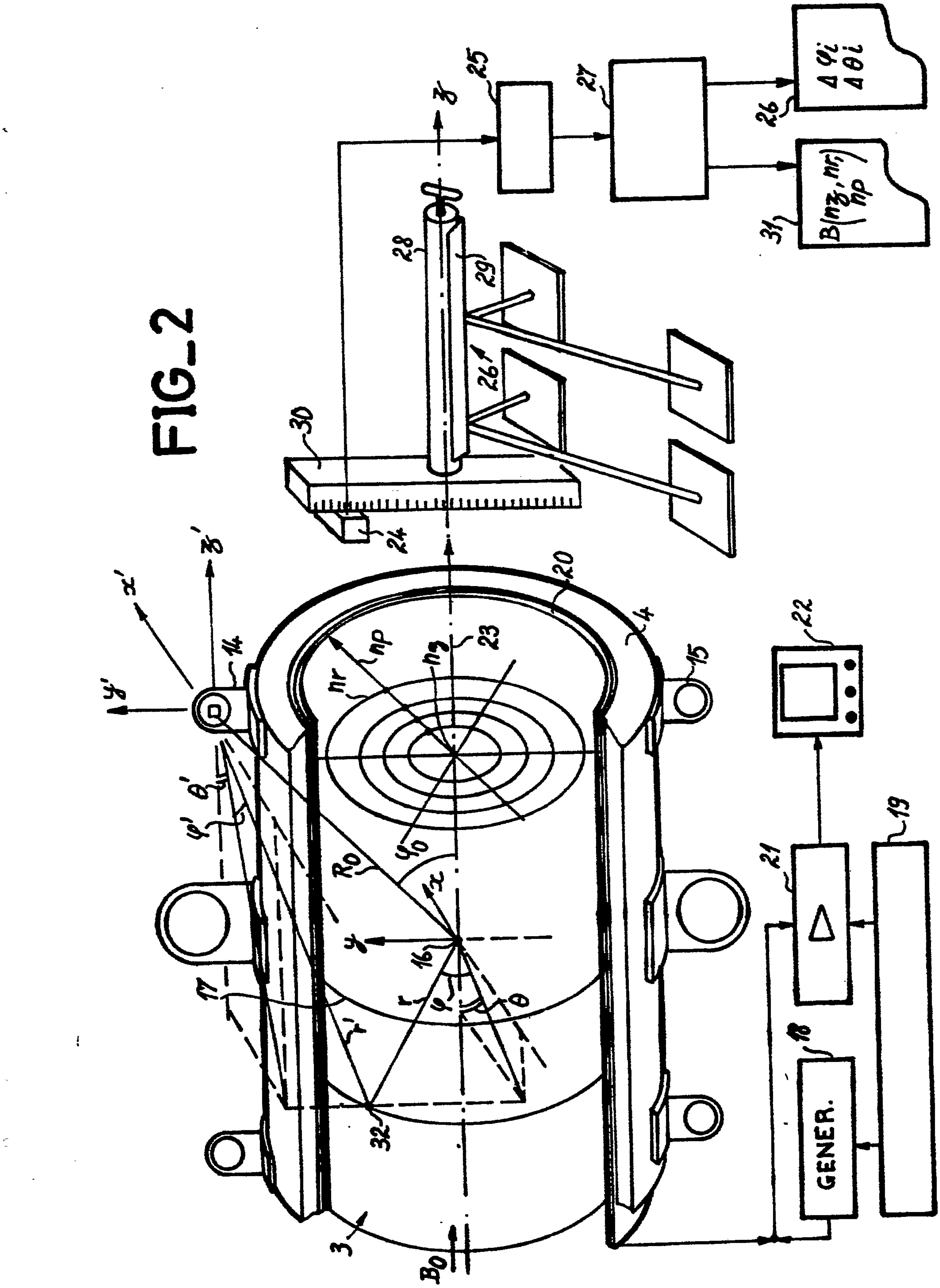

GENER.
B(nz, nr, np)
Δφi
Δθi
Bo
3
4
14
15
16
17
18
19
20
21
22
23
24
25
26
27
28
29
30
31
32
x'
y'
z'
x
y
z
Ro
φo
nr
np
nz
r
r'
φ
θ
φ'
θ'


FIG_2